# FASCICULE DE BREVET EUROPEEN

(11) **EP 3 931 066 B1**
(45) Date de publication et mention de la délivrance du brevet: **08.01.2025**
(21) Numéro de dépôt: 20713718.3
(22) Date de dépôt: 25.02.2020
(51) Int. Cl.: B62D 6/10, G01L 3/10, G01D 5/04, G01D 5/14, G01L 5/22

(54) **CAPTEUR DE POSITION, NOTAMMENT DESTINÉ À LA DÉTECTION DE LA TORSION D'UNE COLONNE DE DIRECTION**
POSITIONSSENSOR, INSBESONDERE ZUR ERFASSUNG DER TORSION IN EINER LENKSÄULE
POSITION SENSOR, DESIGNED IN PARTICULAR FOR DETECTING TORSION IN A STEERING COLUMN

(30) Priorité: 25.02.2019 FR 1901907
(43) Date de publication de la demande: 05.01.2022
(73) Titulaire: Moving Magnet Technologies, 25000 Besançon (FR)
(72) Inventeur: FRACHON, Didier, 25000 Besançon (FR)
(74) Mandataire: IP Trust
(86) Numéro de dépôt international: PCT/FR2020/050353
(87) Numéro de publication internationale: WO 2020/174171

(56) Documents cités:
- WO-A2-2014/012893
- JP-A- 2009 020 064
- US-A1- 2016 214 648

## Description

### Domaine de l'invention

La présente invention concerne le domaine des capteurs magnétiques de position ou de couple comportant une partie aimantée mobile par rapport à une structure de collecte des flux magnétiques vers un entrefer dans lequel est logé une sonde magnétosensible, par exemple une sonde de Hall. Le déplacement relatif peut être rotatif ou linéaire, voire selon des trajectoires quelconques. De tels capteurs sont notamment utilisés dans le domaine de l'automobile, par exemple pour détecter la position d'un arbre ou encore la position d'une colonne de direction comportant un arbre de torsion ou encore dans le domaine de la robotique.

L'amélioration de la sensibilité des sondes magnétosensibles et la multiplication des sources de perturbation électromagnétique dans l'environnement dans lequel sont utilisés de tels capteurs conduit à un problème croissant de fiabilité du signal électrique délivré par de tels capteurs. En effet, ce signal est l'image non seulement du champ magnétique produit par la partie aimantée du capteur, mais aussi de tous les champs magnétiques et électromagnétiques provenant de sources parasites extérieures.

L'objectif de l'invention est de réduire l'effet de ces perturbations.

### Etat de la technique

Afin d'éviter que le capteur magnétique détecte un flux magnétique causé par le champ magnétique externe, empêchant de ce fait une détection précise, le brevet DE102012014208 propose un capteur de couple détectant un couple généré dans un élément de rotation formé par un premier élément d'arbre et un second élément d'arbre qui sont tous deux connectés par l'intermédiaire d'une barre de torsion.

On connaît également la demande de brevet JP2009020064, qui vis à fournir un capteur de couple de taille réduite et d'efficacité considérablement améliorée. Le capteur de couple comporte: des premier et deuxième arbres connectés coaxialement par l'intermédiaire d'un arbre de connexion; un aimant permanent en forme d'anneau fixé au deuxième arbre et magnétisé circonférentiellement avec plusieurs pôles; une culasse de capteur fixée au premier arbre et formant un circuit magnétique avec l'aimant permanent; une culasse collectrice de magnétisme placée de l'autre côté, dans la direction axiale, de la culasse du capteur à partir de l'aimant permanent et formant un circuit magnétique avec l'aimant permanent et la culasse du capteur; et un capteur de flux magnétique pour détecter le flux magnétique induit par la culasse du capteur et la culasse collectrice de magnétisme. Le capteur de couple détecte, sur la base d'une sortie du capteur de flux magnétique, le couple appliqué à l'un des premier et deuxième arbres. La culasse de capteur est construite à partir de pôles à griffes disposés sur le même plan ou sensiblement sur le même plan, et au moins certains des pôles à griffes sont formés séparés les uns des autres.

On connaît aussi le brevet US2016/214648 décrivant un dispositif pour véhicule automobile comprenant un équipement détecteur de couple de rotation destiné à détecter un couple de rotation appliqué à un arbre de direction du véhicule automobile, et comprenant un équipement détecteur d'angle de braquage destiné à détecter un angle de braquage actuel de l'arbre de direction, dans lequel l'équipement détecteur de couple de rotation présente un stator magnétique qui est conçu pour guider un flux magnétique d'un amant jusqu'à au moins un conducteur de flux et ainsi jusqu'à au moins un capteur magnétique de l'équipement détecteur de couple de rotation, et présente deux parties de stator disposées décalées l'une par rapport à l'autre dans la direction axiale, lesquelles parties de stator présentent respectivement un élément périphérique annulaire s'étendant dans la direction radiale, et dans lequel l'équipement détecteur d'angle de braquage présente au moins un élément de transmission de rotation doté d'un aimant permanent, et un détecteur de champ magnétique destiné à détecter un mouvement de rotation de l'élément de transmission de rotation, dans lequel l'au moins un élément de transmission de rotation doté de l'aimant permanent est disposé dans la direction axiale entre les éléments périphériques et dans lequel l'équipement détecteur d'angle de braquage présente un rotor doté d'une structure dentée et l'élément de transmission de rotation est réalisé sous la forme d'une roue dentée qui peut être mise en prise avec la structure dentée du rotor et au moyen de laquelle un mouvement de rotation du rotor peut être converti en un mouvement de rotation de l'aimant permanent, caractérisé en ce que l'équipement détecteur d'angle de braquage comprend une transmission par engrenage dotée d'au moins deux roues dentées dont les dents s'engrènent dans celles du rotor et sont ainsi couplées au rotor, dans lequel un aimant permanent est disposé dans une roue dentée et l'axe de rotation de la roue dentée est parallèle à l'axe de rotation de l'arbre de direction.

### Inconvénients de l'art antérieur

Les solutions envisageables consistent à augmenter le champ magnétique utile par augmentation des dimensions de l'aimant ou du Br de l'aimant, permettant dans une certaine mesure de diluer l'influence de la perturbation mais au prix d'une perte de compacité du capteur et d'un coût augmenté.

L'ajout d'un blindage localisé à proximité des sondes ou constituant une boîte entourant le capteur est une technique connue également mais qui implique des pièces additionnelles souvent volumineuses voire réalisées dans un matériau coûteux en raison d'une haute perméabilité. Cette technique s'accompagne aussi souvent d'une perte de champ magnétique utile en raison de la création de chemin de fuite.

Les solutions consistant à prévoir une pièce additionnelle de blindage magnétique ne sont pas satisfaisantes car elles conduisent à des capteurs comportant un nombre de pièces plus élevé que les capteurs habituels et conduisant à un coût de fabrication et d'assemblage plus élevé.

### Solution apportée par l'invention

Afin de répondre à ces inconvénients, la présente invention a pour but, non pas de créer un blindage magnétique au champ perturbateur extérieur comme l'homme de métier y serait conduit, mais à créer sur chaque structure collectrice de flux deux zones de collecte de ce champ perturbateur, respectivement nommées zone de collecte primaire et zone de collecte secondaire, agencées de manière particulière par rapport à l'entrefer de mesure.

Le principe de l'invention consiste en effet à amener le champ collecté dans l'entrefer de mesure mais selon deux sens de circulation différents permettant au final d'annuler la composante globale du champ perturbateur. Dans cette optique, il est recherché, préférentiellement mais non limitativement, de collecter autant de champ perturbateur avec la zone de collecte primaire qu'avec la zone de collecte secondaire et d'inverser les deux champs au niveau de l'entrefer, relativement l'un par rapport à l'autre, grâce au positionnement relatif de ces deux zones tout en maximisant le flux utile dans cet entrefer.

Plus particulièrement, en positionnant une zone de collecte primaire d'un côté du plan médian transversal définissant l'entrefer et une zone de collecte secondaire de l'autre côté du plan médian transversal définissant l'entrefer, il est créé, par combinaison de deux structures collectrices de flux, une zone de rebroussement du champ magnétique inversant le sens du champ magnétique collecté traversant l'entrefer. Le flux collecté par les zones de collecte primaire et secondaire de la première structure collectrice s'annule ou se minimise en coopération avec le flux collecté par les zones de collecte primaire et secondaire de la deuxième structure, comme il sera mieux apprécié sur les différentes figures.

la présente invention concerne selon son acception la plus générale un capteur de position, notamment destiné à la détection de la torsion d'une colonne de direction, constitué d'une première structure magnétique aimantée rotorique comprenant une pluralité d'aimants, de deux pièces de collecte de flux qui définissent au moins un entrefer dans lequel est placé au moins un élément magnéto sensible caractérisé en ce que chaque pièce de collecte présente au moins une zone de collecte primaire, située dans la zone de collection du flux d'aimant et prolongée par au moins un prolongement présentant au moins une zone de collecte secondaire, en ce que lesdites zones de collecte secondaire sont terminées par des épanouissements plans formant les deux pôles dudit entrefer et en ce que le plan médian transversal dudit entrefer coupe au moins un desdits prolongements.

### Dans des variantes de réalisation :

- au moins une couronne dentée est positionnée en regard de la structure aimantée
- ledit plan médian est parallèle aux plans des zones de collecte primaire
- lesdites zones de collecte primaire sont parallèles aux zones de collecte secondaire
- ledit prolongement s'étend axialement et perpendiculairement au plan de ladite zone de collecte primaire au-delà dudit plan médian transversal
- la surface totale de la zone de collecte secondaire est égale à la surface totale de la zone de collecte primaire
- il comprend en outre un capteur de la torsion de ladite colonne constitué d'une première structure magnétique aimantée rotorique comprenant une pluralité d'aimants, de deux pièces de collecte de flux qui définissent au moins un entrefer dans lequel est placé au moins un élément magnéto sensible, chaque pièce de collecte présentant au moins une zone de collecte primaire prolongée par au moins un prolongement présentant au moins une zone de collecte secondaire, lesdites zones de collecte secondaire étant terminées par des épanouissements plans formant les deux pôles dudit entrefer et le plan médian transversal dudit entrefer coupant au moins un desdits prolongements.

L'invention concerne aussi un dispositif de détection de position absolue d'une colonne de direction caractérisé en ce qu'il comprend en outre un capteur de la torsion de ladite colonne constitué d'une première structure magnétique aimantée rotorique comprenant une pluralité d'aimants, de deux pièces de collecte de flux qui définissent au moins un entrefer dans lequel est placé au moins un élément magnéto sensible, chaque pièce de collecte présentant au moins une zone de collecte primaire prolongée par au moins un prolongement présentant au moins une zone de collecte secondaire, lesdites zones de collecte secondaire étant terminées par des épanouissements plans formant les deux pôles dudit entrefer et le plan médian transversal dudit entrefer coupant au moins un desdits prolongements.

### Description détaillée d'exemples non limitatifs de l'invention

La présente invention sera mieux comprise à la lecture de la description détaillée d'exemples non limitatifs de l'invention qui suit, se référant aux dessins annexés où :
- [Fig 1] La figure 1 représente une vue en perspective d'un premier exemple schématique d'un capteur selon l'invention,
- Les figures 2A, 2B, 2C, 2D 2E et 2F représentent des autres exemples schématiques d'un capteur selon l'invention,
- [Fig 3A - 3B] Les figures 3A et 3B représentent, suivant des vues en perspective respectivement du dessus et du dessous, une variante d'un capteur selon l'invention,
- [Fig4] La figure 4 représente une vue en perspective d'une autre variante de réalisation d'un capteur angulaire
- [Fig 5 - 19] Les figures 5 à 19 représentent toutes des vues en perspective de variantes de réalisation d'un capteur selon l'invention améliorant plusieurs capteurs de l'art antérieur.
- [Fig 20] La figure 20 présente une vue en perspective d'un exemple de réalisation d'un capteur angulaire selon l'invention associé à un capteur de position absolu.
- [Fig 21 - 22] Les figures 21 22 présente des modes de fixation des zones de collecte primaires aux zones de collecte secondaires.

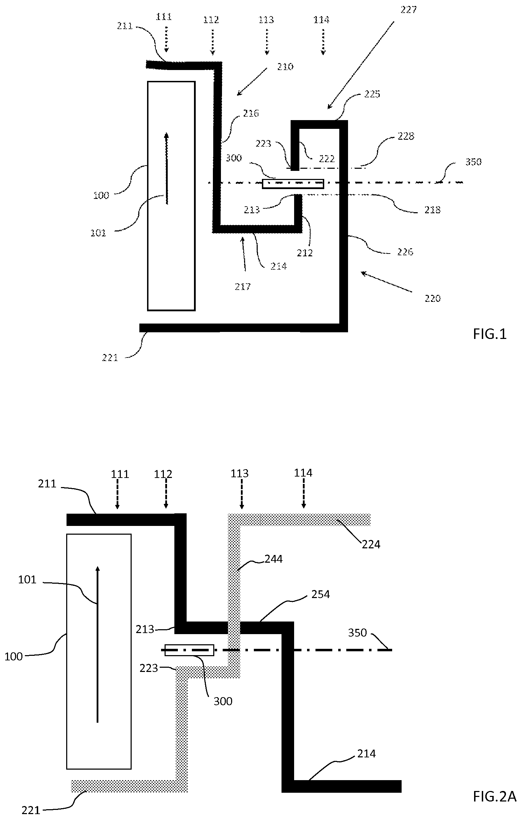

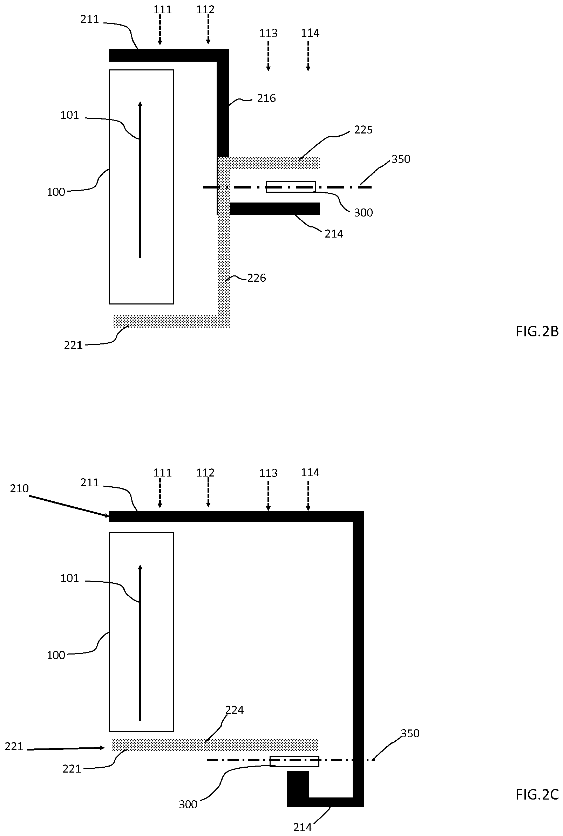

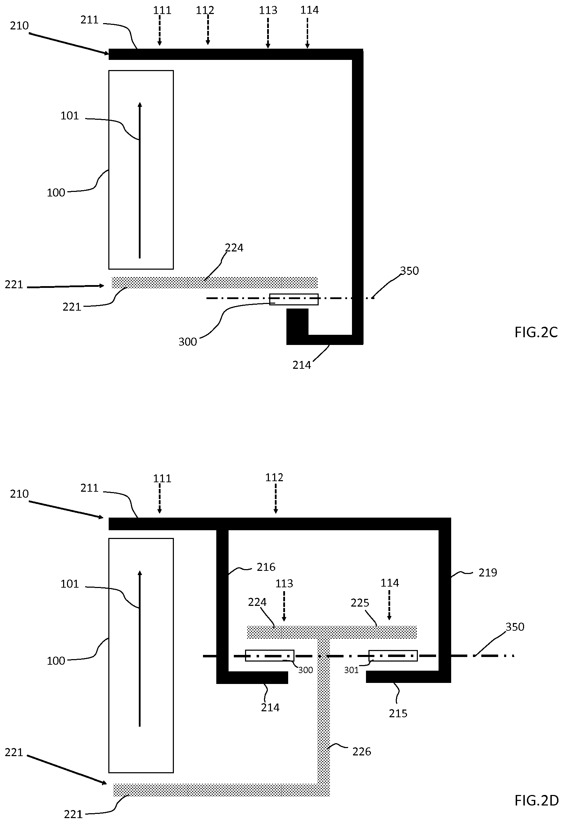

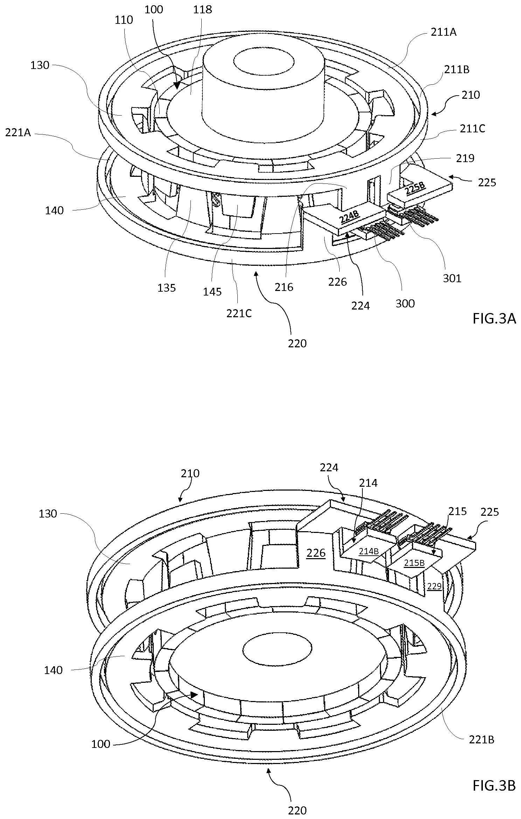

Le principe magnétique sera décrit en référence à des vues schématiques illustrées en figures 1, 2A, 2B, 2C et 2D ainsi qu'en référence plus particulièrement à un mode de réalisation présenté en figures 3A et 3B, mode qui est choisi à titre d'exemple. Les variantes de réalisation illustrées sur les figures restantes reprennent les mêmes principes exposés dans ces premières figures.

### Description d'une première variante de réalisation

La figure 1 représente une vue schématique en coupe d'un exemple de réalisation de l'invention, pour illustrer le principe de fonctionnement magnétique. Le capteur est constitué de manière connue par une structure aimantée (100) mobile par rapport à une seconde structure formée par au moins deux pièces (210, 220), réalisées en matériau ferromagnétique doux constituant des collecteurs de flux principaux et disposées en face de ladite structure aimantée (100).

L'invention s'applique à tout type de combinaison entre une structure aimantée (100) et une deuxième structure, avec un déplacement relatif qui peut être linéaire ou angulaire, et une géométrie discale ou tubulaire pour la mesure d'une position ou d'un couple angulaire.

La structure aimantée (100) est déterminée pour moduler le champ d'induction utile (101) traversant la deuxième structure en fonction de sa position par rapport à cette deuxième structure. Pour cela, différentes configurations sont connues, avec par exemple : juxtaposition d'aimants avec une alternance du sens d'aimantation, structure dans laquelle sont logés des aimants polarisés en sens alternés, aimant à aimantation variable angulairement ou en intensité selon une trajectoire.

Ce champ d'induction utile (101) est collecté par les deux pièces (210, 220) ferromagnétiques doux disposées en face de ladite structure aimantée (100), comprenant chacune une zone de collecte primaire de flux (211, 221) prolongée par une patte de concentration du flux (212, 222). Les zones de collecte primaire de flux (211, 221) sont disposées pour être traversées par le champ utile (101) crée par ladite structure aimantée (100) et par le champ perturbateur. Par soucis de simplicité dans cette représentation schématique, il n'est pas représenté de pièce intermédiaire, équivalent des couronnes dentées (130, 140) qui sont présentes dans les figures 3 à 19 et qui ont la fonction d'améliorer la collecte du flux magnétique et de le diriger vers les zones de collecte primaire (211, 221).

Ce champ d'induction (101) est collecté par les zones de collecte primaire de flux (211, 221) en un matériau ferromagnétique doux, présentant des surfaces de collecte, ici perpendiculaires à la direction du champ d'induction (101) - bien que cette orientation ne soit en rien limitative -, et présentant une forme correspondant à la zone balayée par la face de structure aimantée (100) perpendiculaire à la composante principale de l'aimantation. Ces zones de collecte primaire de flux (211, 221) sont disposées de part et d'autre de la structure aimantée (100). Il est précisé que la direction d'aimantation de la structure aimantée (100) n'est pas limitative et donnée ici à titre d'exemple simplifié. La direction d'aimantation et la forme de la structure aimantée peuvent être différentes.

Des extrémités frontales (213, 223) des pattes de concentration de flux (212, 222) définissent un entrefer dans lequel est logée une sonde de Hall (300), pour former un circuit magnétique à l'intérieur duquel circulent les lignes de champ magnétique. L'induction magnétique mesurée par la sonde de Hall est une fonction directe du champ magnétique traversant les zones de collecte primaire de flux (211, 221). Chaque zone de collecte primaire respectivement (211, 221) prolongée par un prolongement (216, 226) peut être réalisée par découpage et pliage d'une pièce en un matériau ferromagnétique.

L'objet de l'invention est de réduire l'incidence d'un champ magnétique perturbateur, symbolisés par les flèches pointillées (111 à 114), traversant les zones de collecte primaire de flux (211, 221). Ces champs perturbateurs (111 à 114), qui peuvent par ailleurs présenter des orientations différentes de celle verticale présentée ici, sont collectés par les zones de collecte primaire de flux (211, 221) comme le champ utile (100) généré par la structure aimantée (100) et ces flux perturbateurs se retrouvent donc au niveau de la sonde de mesure (300) tout comme le flux utile (100). Ces champs perturbateurs sont également amplifiés par l'effet de concentration dû au matériau ferromagnétique doux des collecteurs et concentrateurs, donc la valeur mesurée par la sonde sera supérieure au champ perturbateur appliqué selon une relation approximativement égale à : Induction mesurée = (Induction utile + Induction perturbatrice) x facteur d'amplification.

La solution proposée par l'invention consiste à créer une compensation en inversant le sens du flux perturbateur au niveau des sondes de mesures (300). Pour cela, on prévoit des zones de collecte secondaire (214, 225).

Les différentes variantes présentées dans ce document proposent de façon non limitative des modes de réalisation permettant de réaliser une telle compensation des flux perturbateurs au niveau de l'entrefer dans lequel est placée la sonde de mesure (300). Dans un mode de réalisation optimum, la collection inversée du flux perturbateur est idéalement identique à la collection directe du flux perturbateur afin d'avoir une annulation complète de la perturbation au niveau des sondes de mesure (300), bien qu'il ne soit pas absolument nécessaire, dans le cadre de l'invention, de réaliser une parfaite annulation.

Dans l'exemple illustré par la figure 1, les zones de collecte secondaire (214, 225) sont constituées par des aires orientées parallèlement aux zones de collecte primaire (211, 221) et présentant une surface cumulée sensiblement identique à la surface cumulée des zones de collecte primaire (211, 221).

L'entrefer présente un plan médian (350) situé entre l'une desdites zone de collecte primaire (211, 221) et l'un des plans (218, 228) défini par l'extrémité frontale (213, 223) de ladite patte de concentration (212, 222) associée. L'extrémité frontale (213, 223) est formée à l'extrémité d'une zone recourbée (217, 227) située en arrière dudit plan médian (350), par rapport à ladite zone de collecte primaire (211, 221), ledit plan médian (350) coupant ladite patte de concentration à un niveau (216, 226) compris entre ladite zone de collecte primaire (211, 221) et ladite zone de collecte secondaire (214, 225).

### Description de variantes schématiques de réalisation

La figure 2A représente une vue schématique en coupe d'un autre exemple de réalisation de l'invention, pour illustrer le principe de fonctionnement magnétique. Dans cet exemple, l'inversion du flux magnétique perturbateur (111 à 114) est réalisé par deux zones de collecte secondaire (214, 224) reliées aux zones frontales (213, 223) des zones de collecte primaire (211, 221) par des concentrateurs de flux additionnels (244, 254) configurés pour inverser, dans l'entrefer au niveau de la sonde (300), le sens des flux collectés par les zones de collecte secondaire (214, 224), par rapport au sens des flux collectés par les zones de collecte primaire (211, 221). Pour cela, au moins une des pièces ferromagnétiques doit être telle que l'entrefer de mesure est situé entre une zone de collecte primaire et une zone de collecte secondaire de ladite pièce.

La figure 2B représente une vue schématique en coupe d'un autre exemple de réalisation de l'invention avec des zones de collecte secondaire (214, 225). Dans cette version, les zones de collecte primaire (211, 221) sont prolongées axialement par des pattes de concentration de flux (216, 226), elles-mêmes prolongées horizontalement par les zones de collecte secondaire (214, 225). L'entrefer de mesure où est placée la sonde (300) est défini entre lesdites zones de collecte secondaire (214, 225). Le plan médian (350) de l'entrefer est dans cet exemple situé entre les zones de collecte primaire (211, 221) et les zones de collecte secondaire (214, 225). L'orientation verticale et horizontale des éléments, citée ci-dessus, n'est en rien limitative et il peut être envisagé des orientations différentes, le but étant d'inverser le sens de circulation de flux perturbateur dans l'entrefer de mesure.

La figure 2C représente une vue schématique en coupe d'un autre exemple de réalisation de l'invention montrant qu'il est seulement nécessaire d'avoir au moins une pièce ferromagnétique (210) telle que l'entrefer dans lequel est placé la sonde (300) est situé entre la zone de collecte primaire (211) et la zone de collecte secondaire (214) de ladite pièce (210).

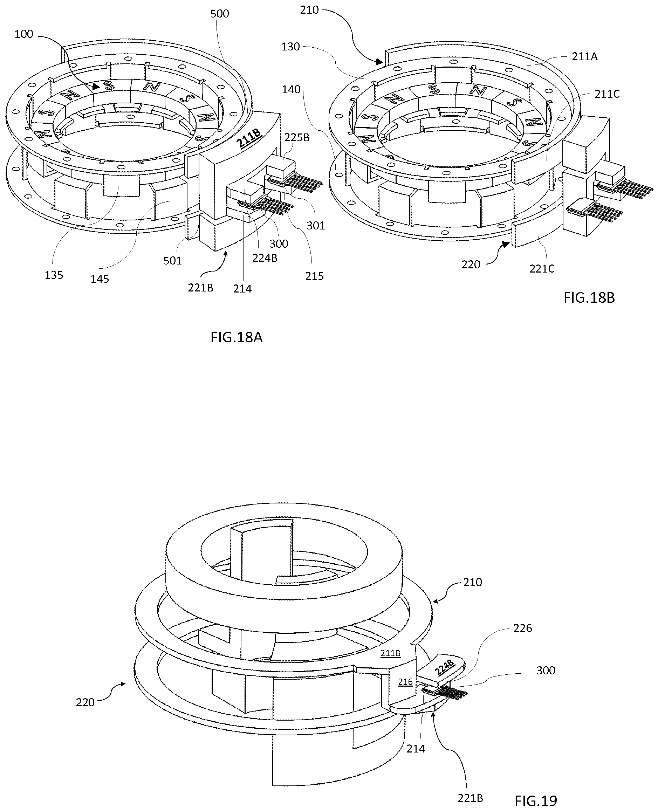

La figure 2D représente une vue schématique en coupe d'un autre exemple de réalisation de l'invention pour laquelle deux sondes (300, 301) sont utilisées. Cette configuration est par ailleurs similaire à celle montrée de manière plus réaliste en figures 18A et 18B, le positionnement radial des sondes y étant remplacé par un positionnement co-radial des sondes avec un espace angulaire entre elles. Les zones de collecte primaires (211, 221) sont prolongées par respectivement deux et une patte de concentration (216, 219 et 226) qui se terminent chacune par des zones de collecte secondaires (214, 215 et 224, 225). Les sondes (300, 301) sont positionnées dans les entrefers entre lesdites zones de collecte secondaires (214, 215 et 224, 225). Pour chaque pièce (210, 220), l'entrefer est situé entre les zones de collecte primaires (211, 221) et les zones de collecte secondaires (214, 215 et 224, 225).

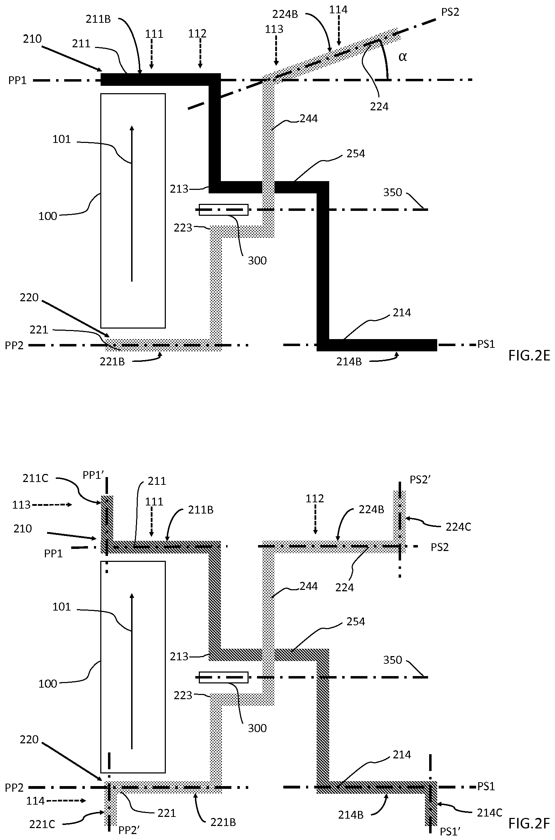

La figure 2E représente une vue schématique en coupe d'un autre exemple de réalisation de l'invention, pour lequel on définit les surfaces de collecte (211B, 221B) des zones de collecte primaires (211, 221) et les surfaces de collecte (214B, 224B) des zones de collecte secondaires (214, 224). Ce schéma représente une coupe dans un plan orthogonal auxdites surfaces de collecte (211B, 214B, 221B, 224B) qui sont respectivement définies par un plan médian (PP1, PS1, PP2, PS2) à chacune de ces surfaces. Cette vue schématique illustre donc que les plans médians des surfaces (211B, 221B) des zones de collection primaires (211, 221), ne sont pas nécessairement parallèles aux plans médians des surfaces (214B, 224B) des zones de collection secondaires (214, 224), ici les plans (PP1, PS2) forment un angle α non nul. Cet exemple est non limitatif et l'on prévoit tout autre combinaison desdits plans (PP1, PS1, PP2, PS2) pouvant former un angle non nul. Toutefois la compensation est avantageuse lorsque les plans (PP1) et (PS2) ou (PP2) et (PS1) forment un angle faible, soit α < 45 degrés, la compensation étant nulle lorsque ces combinaisons impliquent toutes deux des plans orthogonaux, nous excluons cette possibilité. Enfin, le plan médian est introduit de manière à inclure des surfaces de collecte courbes ou bosselées des zones de collecte (211, 214, 221, 224), ainsi le plan médian d'une surface est défini par une minimisation en tout point de la surface de la distance entre ladite surface et ledit plan médian.

La figure 2F représente une vue schématique en coupe d'un autre exemple de réalisation de l'invention. Ce mode réalisation diffère du schéma précédent représenté figure 2E en ce que les zones de collecte (211, 214, 221, 224) possèdent plusieurs surfaces de collecte (211B, 211C, 214B, 214C, 221B, 221C, 224B, 224C) du flux perturbateur. Cette vue schématique est une vue en coupe selon la direction orthogonale auxdites surfaces. Les surfaces de collectes supplémentaires (211C, 214C, 221C, 224C) du flux perturbateur sont respectivement définies par des plans médians (PP1', PS1', PP2', PS2'), et des relations angulaires sont instaurées entre ces plans à l'instar des relations définies entre les plans (PP1, PS1, PP2, PS2) dans le mode de réalisation précédent. Ainsi, au moins une des relations suivantes est vraie, les plans (PP1') et (PS2') ne sont pas orthogonaux ou les plans (PP2') et (PS1') ne sont pas orthogonaux. Dans tout le reste document nous désignerons une surface de collecte associée à une zone de collecte par une lettre A, B, C ou D suivant le numéro identifiant ladite zone. Ainsi par un soucis de clarté, les schéma ne feront pas systématiquement apparaître expressément toutes les zones de collectes, la désignation de la surface étant suffisante pour identifier la zone.

### Description d'un premier exemple de réalisation d'un capteur angulaire

Les figures 3A et 3B représentent un exemple de réalisation d'un capteur angulaire de torsion, pour réaliser une mesure sur une course de quelques degrés (typiquement +/- 3°, +/-6°, +/- 8°) d'un arbre de torsion équipant une colonne de direction. La base de ce capteur est similaire à celle présentée dans le document US20140130612, base que la présente invention cherche à améliorer pour ce qui est de l'immunité au champ magnétique perturbateur.

Le capteur se compose d'une structure aimantée (100) composée d'un aimant cylindrique (110) à 2N paires de pôles (typiquement N=6, 8, 10 ou 12), aimantés préférentiellement - mais non limitativement - radialement pour former une bague montée sur une culasse cylindrique (118) de même hauteur que l'aimant.

Selon cet exemple de réalisation, la structure aimantée (100) comporte en outre deux couronnes dentées (130, 140) montées en vis-à-vis et décalées angulairement d'un angle correspondant au pas polaire de l'aimant (110). Chaque couronne dentée (130, 140) présente N dents (135, 145) se présentant comme des portions de cylindre, orientées axialement de manière à collaborer avec les faces extérieures de l'aimant (110). Les dents font ici apparaître une largeur angulaire vue de l'axe du capteur qui est croissante au niveau du pied, de façon à augmenter la section de passage du flux dans le pied de dent.

Ces couronnes dentées (130, 140) transmettent le flux issu de la structure aimantée (100) aux zones de collecte principales formées dans cet exemple par les pièces ferromagnétiques (210, 220), ici sous la forme d'anneau ou couronne, à travers un entrefer annulaire. Les pièces (210, 220) présentent d'une part une surface de collection radiale (211A, 221A) du flux utile venant de la structure aimantée (100) et aussi une surface de collecte axiale (211B, 221B) collectant une partie du flux utile mais surtout le flux perturbateur extérieur. Les surfaces extérieures (211C, 221C) participent surtout à la collection du flux perturbateur.

Les pièces (210, 220) sont prolongées chacune par deux pattes de concentration, respectivement (216, 219 et 226, 229) et permettent de concentrer et diriger le flux dans deux entrefers de mesure situés radialement à l'extérieur des zones de concentration (216, 218 et 226, 228) et dans lesquels deux éléments magnétosensibles (300, 301) sont placés et maintenus par un circuit imprimé non représenté. Le nombre d'entrefers et d'éléments magnétosensibles utilisés dans cet exemple - mais plus généralement dans tous les exemples présentés - peut être variable en fonction des redondances de signal voulu. Il peut en effet y avoir une, deux ou trois sondes typiquement utilisées dans ces capteurs.

Des zones de collecte secondaires (224, 225) de la pièce (220) sont constituées par deux aires transversales supérieures (224B, 225B) s'étendant dans un plan parallèle aux plans de la surface de collecte (221B) et situé en arrière du plan médian transversal passant par les entrefers dans lesquels sont placés les sondes de Hall (300, 301). Ce plan médian est ainsi placé entre :
- le plan du secteur de collecte primaire (221B) prolongé par les pattes de concentration (226, 229) associée,
- le plan des aires de collecte secondaire (224B, 225B) associées, parallèle audit plan du secteur de collecte primaire (221B).

Ces trois plans (221B, 224B, 225B) sont parallèles dans l'exemple décrit bien que ceux-ci ou l'un de ceux-ci puissent être inclinés sans sortir du cadre de l'invention. Le plan médian des entrefers intersecte les pattes de concentration (226, 229).

De manière similaire, des zones de collecte secondaire (214, 215) de la pièce (210) sont constituées par deux aires transversales supérieures (214B, 215B) s'étendant dans un plan parallèle aux plans de la surface de collecte primaire (211B) et situé en arrière du plan médian transversal passant par les entrefers dans lesquels sont placés les sondes de Hall (300, 301). Ce plan médian est ainsi placé entre :
- le plan du secteur de collecte primaire (211B) prolongé par les pattes de concentration (216, 219) associée,
- le plan des aires de collecte secondaire (214B, 215B) associées, parallèle audit plan du secteur de collecte primaire (211B).

Ces trois plans (211B, 214B, 215B) sont parallèles dans l'exemple décrit bien que ceux-ci ou l'un de ceux-ci puissent être inclinés sans sortir du cadre de l'invention. Le plan médian des entrefers intersecte les pattes de concentration (216, 219).

### Description de plusieurs exemples de réalisation d'un capteur angulaire

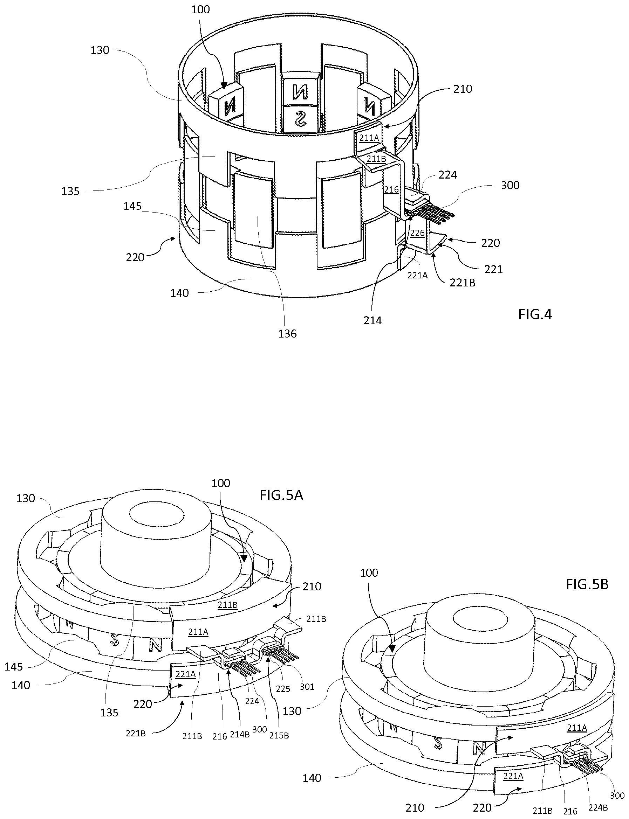

La figure 4 illustre l'application de la présente invention à un capteur tel que présenté dans le document US20140283623. De même que précédemment, ce capteur comprend une structure aimantée (100) mobile relativement à des couronnes dentées (130, 140) dirigeant le flux vers les pièces ferromagnétiques (210, 220) de concentration et un entrefer de mesure dans lequel est située ici une seule sonde (300).

Lesdites pièces ferromagnétiques (210, 220) sont formées d'une surface de collecte primaire (211A, 221A) collectant sur son intérieur le flux utile de la structure aimantée (100) et le flux perturbateur extérieur sur sa tranche et son extérieur. Les surfaces de collecte primaire (211B, 221B) collectent principalement la composante axiale du flux perturbateur, ces surfaces étant prolongées par des pattes de concentration (216, 226) jusqu'à former à leur extrémité des zones de collecte secondaire (214, 224) entre lesquelles est positionnée la sonde (300). Le flux perturbateur est d'une part orienté dans l'entrefer dans le sens direct entre les zones de collecte secondaire (214, 225) et dans le sens inverse par les zones de collectes (211B, 221B), participant toutes à minimiser voir annuler le flux perturbateur dans l'entrefer de mesure.

Les figures 5A et 5B illustrent l'application de la présente invention à un capteur tel que présenté dans le document US20090027045. De même que précédemment, ce capteur comprend une structure aimantée (100) mobile relativement à des couronnes dentées (130, 140) dirigeant le flux vers les pièces ferromagnétiques (210, 220) de concentration et un entrefer de mesure dans lequel est située ici une ou deux sondes (300, 301). Les dents (135, 145) des couronnes (130, 140) s'étendent ici radialement et non axialement comme précédemment montré en figure 4. La figure 5A présente une seule sonde de mesure (300), et la figure 5B présente deux sondes (300, 301), les fonctions restant par ailleurs identiques entre les deux sous-variantes.

Lesdites pièces ferromagnétiques (210, 220) sont formées d'une surface de collecte primaire (211A, 221A) collectant sur son intérieur le flux utile de la structure aimantée (100) et le flux perturbateur extérieur sur son extérieur. Des surfaces de collecte secondaire (211B, 221B) des zones de collecte primaires (211, 221) collectent le flux utile et le flux perturbateur, ces surfaces étant prolongées par des pattes de concentration (216, 226) jusqu'à former à leur extrémité des zones de collecte secondaire (214, 224, 215, 225) entre lesquelles est positionnée les sondes (300, 301). Le flux perturbateur est d'une part orienté dans l'entrefer dans le sens direct entre les zones de collecte secondaire (214, 224, 215, 225) et dans le sens inverse par les zones de collectes (211, 216, 221, 226), participant toutes à minimiser voir annuler le flux perturbateur dans l'entrefer de mesure.

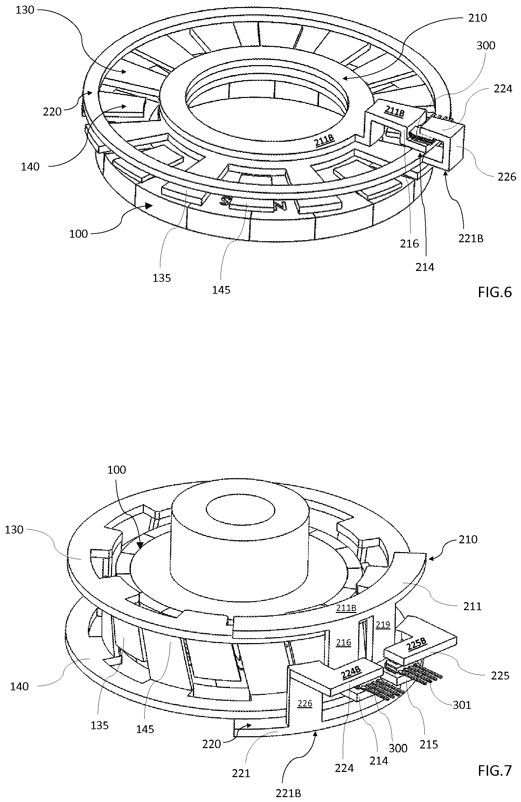

La figure 6 illustre l'application de la présente invention à un capteur tel que présenté dans le document JP200920064. De même que précédemment, ce capteur comprend une structure aimantée (100) mobile relativement à des couronnes dentées (130, 140) dirigeant le flux vers les pièces ferromagnétiques (210, 220) de concentration et un entrefer de mesure dans lequel est située ici une seule sonde (300). Dans cet exemple, la structure aimantée est positionnée sous les couronnes dentées (130, 140).

Lesdites pièces ferromagnétiques (210, 220) sont formées d'une surface de collecte primaire (211B, 221B) collectant sur son intérieur le flux utile de la structure aimantée (100) et le flux perturbateur extérieur sur son extérieur. Ces surfaces (211B, 221B) sont prolongées par des pattes de concentration (216, 226) jusqu'à former à leur extrémité des zones de collecte secondaire (214, 224) entre lesquelles est positionnée la sonde (300). Le flux perturbateur est d'une part orienté dans l'entrefer dans le sens direct entre les zones de collecte secondaire (214, 224) et dans le sens inverse par les zones de collectes (211B, 216, 221B, 226), participant toutes à minimiser voir annuler le flux perturbateur dans l'entrefer de mesure.

La figure 7 illustre l'application de la présente invention à un capteur tel que présenté dans le document KR20120010696. De même que précédemment, ce capteur comprend une structure aimantée (100) mobile relativement à des couronnes dentées (130, 140) dirigeant le flux vers les pièces ferromagnétiques (210, 220) de concentration et un entrefer de mesure dans lequel est située ici une seule sonde (300). Dans cet exemple, les dents (135, 145) des couronnes (130, 140) sont inclinées angulairement.

Lesdites pièces ferromagnétiques (210, 220) sont formées de surfaces de collecte (211B, 221B) des zones de collecte primaires (211, 221) collectant sur leur intérieur le flux utile de la structure aimantée (100) et le flux perturbateur sur leur extérieur. Ces surfaces (211B, 221B) sont prolongées par des pattes de concentration (216, 219, 226) jusqu'à former à leur extrémité des zones de collecte secondaire (214, 215, 224, 225) entre lesquelles sont positionnées les sondes (300, 301). Le flux perturbateur est d'une part orienté dans l'entrefer dans le sens direct entre les zones de collecte secondaire (214, 215, 224, 225) et dans le sens inverse par les zones de collectes (211, 216, 219, 221B, 226), participant toutes à minimiser voir annuler le flux perturbateur dans l'entrefer de mesure.

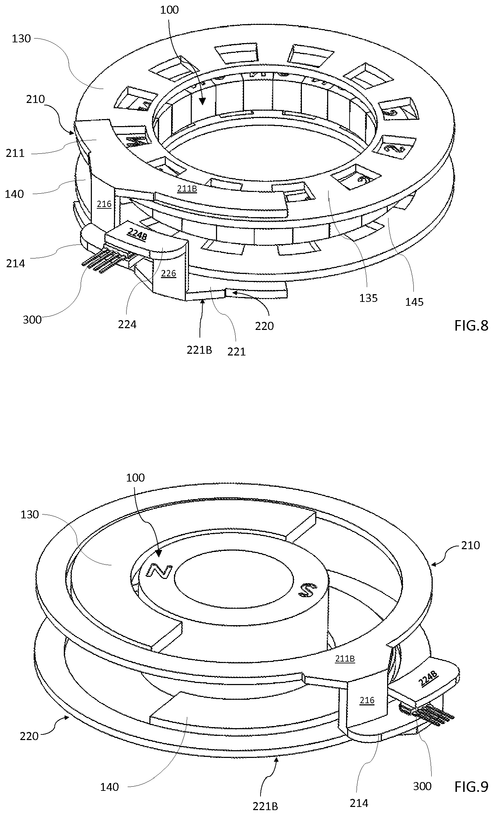

La figure 8 illustre l'application de la présente invention à un capteur tel que présenté dans le document JP2012058249. De même que précédemment, ce capteur comprend une structure aimantée (100) mobile relativement à des couronnes dentées (130, 140) dirigeant le flux vers les pièces ferromagnétiques (210, 220) de concentration et un entrefer de mesure dans lequel est située ici une seule sonde (300). Dans cet exemple, les couronnes (130, 140) sont planes et ne présentent pas de dents découpées et la collecte de flux utile se fait axialement, similairement à la vue schématique de la figure 1.

Lesdites pièces ferromagnétiques (210, 220) sont formées de surfaces de collecte primaire (211B, 221B) collectant sur leur intérieur le flux utile de la structure aimantée (100) et le flux perturbateur extérieur sur leur extérieur. Ces surfaces (211B, 221B) sont prolongées par des pattes de concentration (216, 226) jusqu'à former à leur extrémité des zones de collecte secondaire (214, 224) entre lesquelles est positionnée la sonde (300). Le flux perturbateur est d'une part orientée dans l'entrefer dans le sens direct entre les zones de collecte secondaire (214, 224) et dans le sens inverse par les zones de collectes (211B, 221B, 216, 226), participant toutes à minimiser voire annuler le flux perturbateur dans l'entrefer de mesure.

La figure 9 illustre l'application de la présente invention à un capteur tel que présenté dans le document JP2016090492. De même que précédemment, ce capteur comprend une structure aimantée (100) mobile relativement à des couronnes (130, 140) dirigeant le flux vers les pièces ferromagnétiques (210, 220) de concentration et un entrefer de mesure dans lequel est située ici une seule sonde (300). Dans cet exemple, les couronnes (130, 140) sont planes et ne présentent pas de dents.

Lesdites pièces ferromagnétiques (210, 220) sont formées de surfaces de collecte primaire (211B, 221B) collectant sur leur intérieur le flux utile de la structure aimantée (100) et le flux perturbateur extérieur sur leur extérieur. Ces surfaces (211B, 221B) sont prolongées par des pattes de concentration (216, 226 -non visible-) jusqu'à former à leur extrémité des zones de collecte secondaire (214, 224) entre lesquelles est positionnée la sonde (300). Le flux perturbateur est d'une part orienté dans l'entrefer dans le sens direct entre les zones de collecte secondaire (214, 224) et dans le sens inverse par les zones de collectes (211, 216, 226, 221), participant toutes à minimiser voir annuler le flux perturbateur dans l'entrefer de mesure.

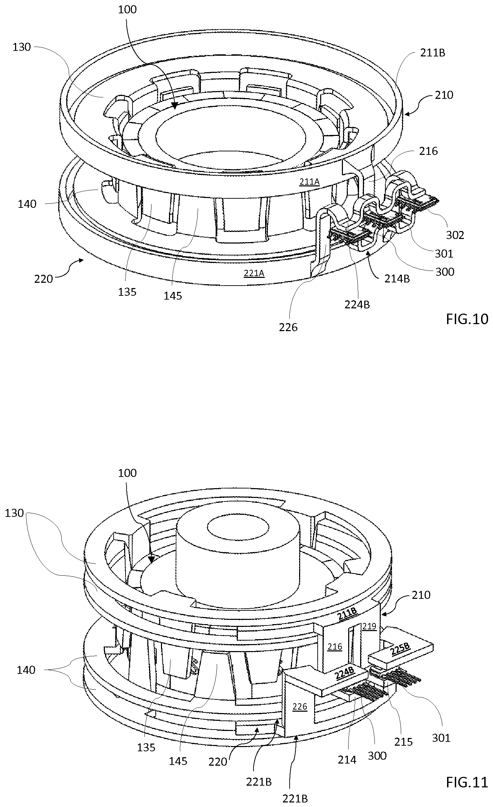

La figure 10 illustre l'application de la présente invention à un capteur tel que présenté dans le document US20090078058. De même que précédemment, ce capteur comprend une structure aimantée (100) mobile relativement à des couronnes (130, 140) dirigeant le flux vers les pièces ferromagnétiques (210, 220) de concentration et un entrefer de mesure dans lequel est située ici trois sondes (300, 301, 302). Dans cet exemple, les pièces ferromagnétiques (210, 220) ont une épaisseur axiale plus importante que les couronnes dentées (130, 140).

Lesdites pièces ferromagnétiques (210, 220) sont formées de surfaces de collecte primaire (211A, 221A) collectant sur leur intérieur le flux utile de la structure aimantée (100) et le flux perturbateur sur la tranche et leur extérieur. Ces surfaces (211A, 221A) sont prolongées par des pattes de concentration (216, 226) jusqu'à former à leur extrémité des zones de collecte secondaire (214, 224) entre lesquelles sont positionnées ici trois sondes (300, 301, 302). Le flux perturbateur est d'une part orienté dans l'entrefer dans le sens direct entre les zones de collecte secondaire (214, 224) et dans le sens inverse par les zones de collectes (211, 221), participant toutes à minimiser voir annuler le flux perturbateur dans l'entrefer de mesure.

La figure 11 illustre l'application de la présente invention à un capteur tel que présenté dans le document KR976701. De même que précédemment, ce capteur comprend une structure aimantée (100) mobile relativement à des couronnes (130, 140) dirigeant le flux vers les pièces ferromagnétiques (210, 220) de concentration et un entrefer de mesure dans lequel est située ici deux sondes (300, 301). Dans cet exemple, les couronnes dentées (130, 140) sont doublées pour augmenter la surface de collecte de flux utile.

Lesdites pièces ferromagnétiques (210, 220) sont formées de zones de collecte primaires (211, 221) collectant le flux utile de la structure aimantée (100) sur leur surface intérieure (211A, 221A) et le flux perturbateur sur leur surface extérieure (211B, 221B). Ces surfaces (211B, 221B) sont prolongées par des pattes de concentration (216, 219, 226) jusqu'à former à leur extrémité des zones de collecte secondaire (214, 215, 224, 225) entre lesquelles sont positionnées ici deux sondes (300, 301). Le flux perturbateur est d'une part orienté dans l'entrefer dans le sens direct entre les zones de collecte secondaire (214, 215, 224, 225) et dans le sens inverse par les zones de collectes (211, 221), participant toutes à minimiser voir annuler le flux perturbateur dans l'entrefer de mesure.

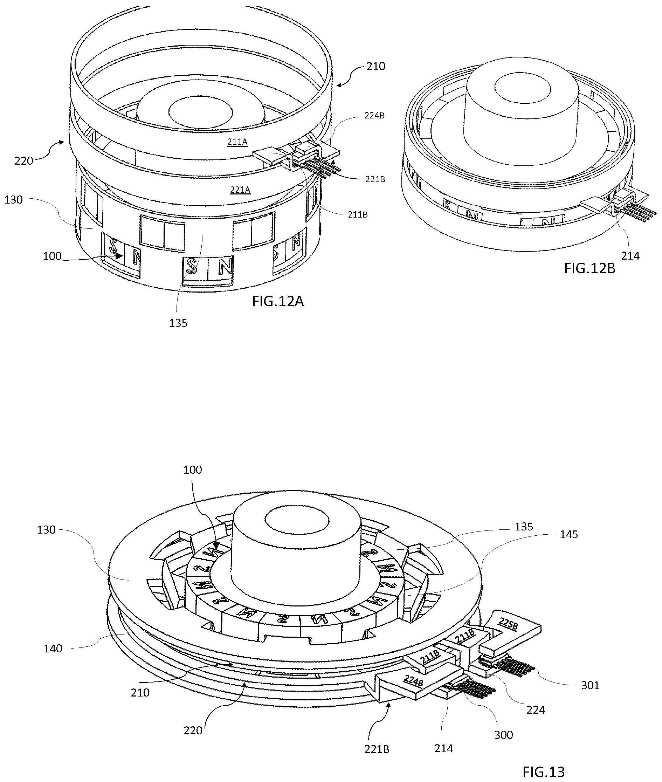

Les figures 12A et 12B illustrent l'application de la présente invention à un capteur tel que présenté dans le document KR987896. De même que précédemment, ce capteur comprend une structure aimantée (100) mobile relativement à une couronne unique (130) dirigeant le flux vers les pièces ferromagnétiques (210, 220) de concentration et un entrefer de mesure dans lequel est située ici une seule sonde (300). Dans cet exemple, la couronne (130) est unique et ne présente pas de dents découpées. La figure 12A présente une vue éclatée du capteur, et la figure 12B présente une vue assemblée du capteur.

Lesdites pièces ferromagnétiques (210, 220) sont formées de surfaces de collecte primaire (211A, 221A) collectant le flux utile de la structure aimantée (100) et le flux perturbateur sur la tranche et leur extérieur. Ces surfaces (211A, 221A) sont prolongées par des surfaces (211B, 221B) et ensuite par des pattes de concentration (216, 219, 226) jusqu'à former à leur extrémité des zones de collecte secondaire (214, 224) entre lesquelles sont positionnées ici une sonde (300). Le flux perturbateur est d'une part orienté dans l'entrefer dans le sens direct entre les zones de collecte secondaire (214, 224) et dans le sens inverse par les zones de collectes (211A, 211B, 221A, 221B), participant toutes à minimiser voir annuler le flux perturbateur dans l'entrefer de mesure.

La figure 13 illustre l'application de la présente invention à un capteur tel que présenté dans le document WO2016032785. De même que précédemment, ce capteur comprend une structure aimantée (100) mobile relativement à des couronnes (130, 140) dirigeant le flux vers les pièces ferromagnétiques (210, 220) de concentration et un entrefer de mesure dans lequel est située ici une deux sondes (300, 301). Dans cet exemple, les couronnes dentées (130, 140) présentent des dents (135, 145) qui sont inclinées radialement.

Lesdites pièces ferromagnétiques (210, 220) sont sous la forme d'anneaux et sont formées de surfaces de collecte primaire (211B, 221B) collectant le flux utile de la structure aimantée (100) et le flux perturbateur sur leur extérieur. Ces surfaces (211B, 221B) sont prolongées par des pattes de concentration (non pointées) jusqu'à former à leur extrémité des zones de collecte secondaire (214, 215, 224, 225) entre lesquelles sont positionnées ici deux sondes (300, 301). Le flux perturbateur est d'une part orienté dans l'entrefer dans le sens direct entre les zones de collecte secondaire (214, 215, 224, 225) et dans le sens inverse par les zones de collectes (211B, 221B), participant toutes à minimiser voir annuler le flux perturbateur dans l'entrefer de mesure.

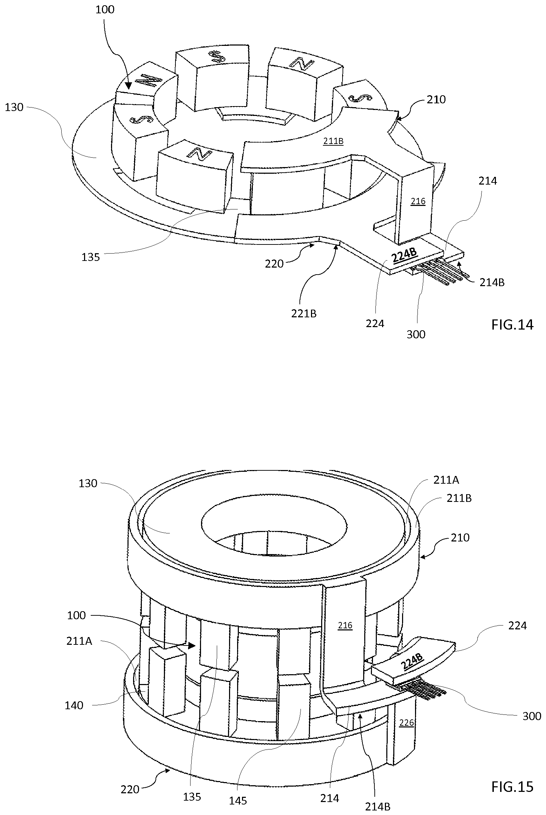

La figure 14 illustre l'application de la présente invention à un capteur tel que présenté dans le document KR2016029991. De même que précédemment, ce capteur comprend une structure aimantée (100) mobile relativement à une couronne (130) dirigeant le flux vers les pièces ferromagnétiques (210, 220) de concentration et un entrefer de mesure dans lequel est située ici une sonde (300). Dans cet exemple, la couronne dentée (130) est unique et présente des dents (135) qui s'étendent radialement.

Lesdites pièces ferromagnétiques (210, 220) sont sous la forme de secteurs et sont formées de surfaces de collecte primaire (211B, 221B) collectant le flux utile de la structure aimantée (100) sur leur intérieur et le flux perturbateur sur leur extérieur. La surface (211B) est prolongée par une patte de concentration (216) jusqu'à former à son extrémité des zones de collecte secondaire (214, 224) entre lesquelles sont positionnées ici une sonde (300). Le flux perturbateur est d'une part orienté dans l'entrefer dans le sens direct entre les zones de collecte secondaire (214, 224) et dans le sens inverse par les zones de collectes (211, 221), participant toutes à minimiser voir annuler le flux perturbateur dans l'entrefer de mesure.

La figure 15 illustre l'application de la présente invention à un capteur tel que présenté dans le document JP6036220. De même que précédemment, ce capteur comprend une structure aimantée (100) mobile relativement à deux couronnes (130, 140) dirigeant le flux vers les pièces ferromagnétiques (210, 220) de concentration et un entrefer de mesure dans lequel est située ici une sonde (300). Dans cet exemple, les dents (135, 145) des couronnes (130, 140) se prolongent axialement et sont colinéaires entre chaque couronne (130, 140). La structure aimantée (100) est polarisée axialement.

Lesdites pièces ferromagnétiques (210, 220) sont sous la forme de secteurs et sont formées de zones de collecte primaire (211, 221) collectant le flux utile de la structure aimantée (100) sur les surfaces de collecte (211A, 221A) et le flux perturbateur sur les surfaces de collecte (211B, 221B). Les zones de collecte (211, 221) sont prolongées par une patte de concentration (216, 226) jusqu'à former à son extrémité des zones de collecte secondaire (214, 224) entre lesquelles sont positionnées ici une sonde (300). Le flux perturbateur est d'une part orienté dans l'entrefer dans le sens direct entre les zones de collecte secondaire (214, 224) et dans le sens inverse par les zones de collectes (211, 221), participant toutes à minimiser voir annuler le flux perturbateur dans l'entrefer de mesure.

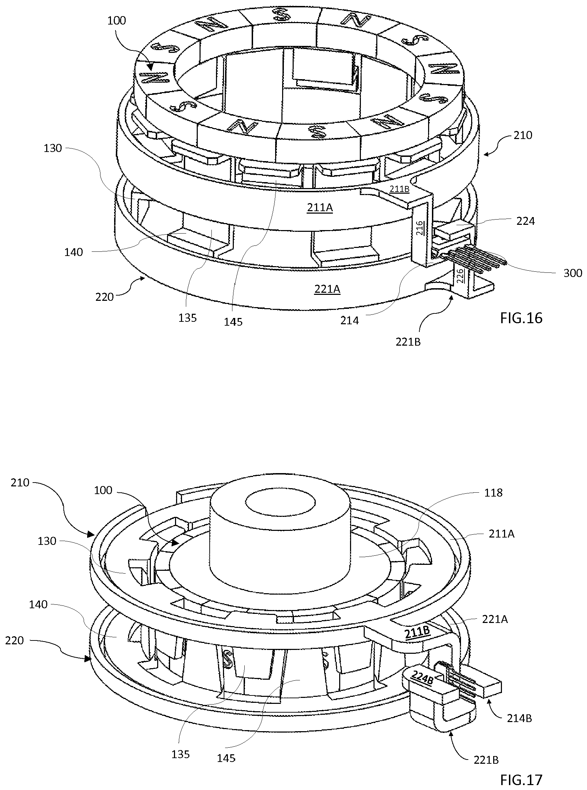

La figure 16 illustre l'application de la présente invention à un capteur tel que présenté dans le document US20160138983. De même que précédemment, ce capteur comprend une structure aimantée (100) mobile relativement à deux couronnes dentées (130, 140) dirigeant le flux vers les pièces ferromagnétiques (210, 220) de concentration et un entrefer de mesure dans lequel est située ici une sonde (300). Dans cet exemple, les dents (135, 145) des couronnes (130, 140) constituent ensemble les couronnes (130, 140). La structure aimantée (100) est polarisée axialement est située au-dessus desdites couronnes (130, 140).

Lesdites pièces ferromagnétiques (210, 220) sont sous la forme de secteurs et sont formées de zones de collecte primaire (211, 221) collectant le flux utile de la structure aimantée (100) sur les surfaces de collecte (211A, 221A) et le flux perturbateur sur les surfaces de collecte (211B, 221B). Les zones de collecte (211, 221) sont prolongées par une patte de concentration (216, 226) jusqu'à former à son extrémité des zones de collecte secondaire (214, 224) entre lesquelles sont positionnées ici une sonde (300). Le flux perturbateur est d'une part orienté dans l'entrefer dans le sens direct entre les zones de collecte secondaire (214, 224) et dans le sens inverse par les zones de collectes (211, 221, 216, 226), participant toutes à minimiser voir annuler le flux perturbateur dans l'entrefer de mesure.

La figure 17 illustre l'application de la présente invention à un capteur dont le plan de sonde (300) est orienté axialement ou à 90° par rapport aux descriptions précédentes. De même que précédemment, ce capteur comprend une structure aimantée (100) mobile relativement à deux couronnes dentées (130, 140) dirigeant le flux vers les pièces ferromagnétiques (210, 220) de concentration et un entrefer de mesure dans lequel est située ici une sonde (300). Dans cet exemple, les dents (135, 145) des couronnes (130, 140) constituent ensemble les couronnes (130, 140). La solution apportée par la présente invention permet aussi de minimiser la perturbation d'un champ extérieur orienté perpendiculairement à l'axe de rotation du capteur.

Lesdites pièces ferromagnétiques (210, 220) sont sous la forme de secteurs et sont formées de surfaces de collecte primaire (211A, 221A) collectant le flux utile de la structure aimantée (100). Les surfaces (211B, 221B) sont prolongées à leur extrémité par des zones de collecte secondaire (214, 224) entre lesquelles est positionnée ici une sonde (300). Le flux perturbateur est d'une part orienté dans l'entrefer dans le sens direct entre les zones de collecte secondaire (214, 224) et dans le sens inverse par les zones de collectes (211B, , 221B), participant à minimiser voir annuler le flux perturbateur dans l'entrefer de mesure.

Les figures 18A et 18B illustrent l'application de la présente invention à un capteur tel que décrit dans le document US8418570. De même que précédemment, ce capteur comprend une structure aimantée (100) mobile relativement à deux couronnes dentées (130, 140) dirigeant le flux vers les pièces ferromagnétiques (210, 220) de concentration et un entrefer de mesure dans lequel est située ici deux sondes (300, 301). Dans cet exemple, les pièces ferromagnétiques (210, 220) sont en deux parties générant un entrefer additionnel (500, 501). La figure 18A est une vue complète du dispositif alors que la figure 18B est une vue où les pièces ferromagnétiques (210, 220) sont tronquées selon un plan axial pour mieux apprécier la forme des éléments.

Lesdites pièces ferromagnétiques (210, 220) sont sous la forme de secteurs et sont formées de surfaces de collecte primaire (211, 221) collectant le flux utile de la structure aimantée (100) sur leur intérieur (211A) et le flux perturbateur sur leur tranche (211B, 221B) et leur extérieur (211C, 221C). Les zones (211, 221) sont prolongées à leur extrémité par des zones de collecte secondaire (214, 215, 224, 225) entre lesquelles sont positionnées ici deux sondes (300). Le flux perturbateur est d'une part orienté dans l'entrefer dans le sens direct entre les zones de collecte secondaire (214, 215, 224, 225) et dans le sens inverse par les zones de collectes (211, 221), participant toutes à minimiser voir annuler le flux perturbateur dans l'entrefer de mesure.

La figure 19 illustre l'application de la présente invention à un capteur tel que décrit dans le document JP2016095281. Lesdites pièces ferromagnétiques (210, 220) sont sous la forme d'anneaux et sont formées de surfaces de collecte primaire (211B, 221B) collectant le flux utile de la structure aimantée (100) et le flux perturbateur. Les surfaces (211B, 221B) sont prolongées par des pattes de concentration (216, 226) et à leur extrémité par des zones de collecte secondaire (214, 224) entre lesquelles est positionnée ici une sonde (300). Le flux perturbateur est d'une part orienté dans l'entrefer dans le sens direct entre les zones de collecte secondaire (214, 224) et dans le sens inverse par les zones de collectes (211B, 221B), participant toutes à minimiser voir annuler le flux perturbateur dans l'entrefer de mesure.

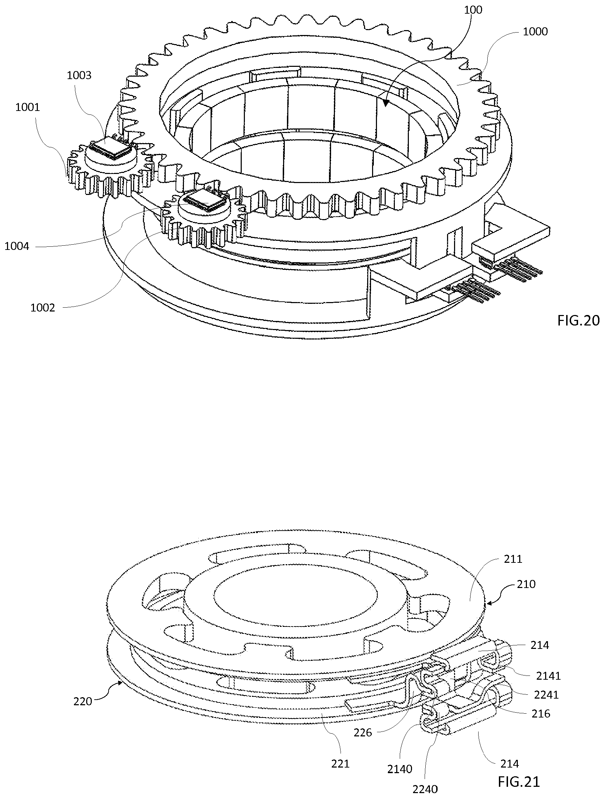

La figure 20 présente l'association d'un capteur de position tel que défini par l'invention avec un dispositif de détection de position absolue. Dans cet exemple non limitatif, un capteur de position tel que défini en figures 3A, 3B est associé à un dispositif semblable à celui décrit dans le document WO2012084288. Ce dernier dispositif, utilisant un principe de mesure par vernier magnétique, est destiné à déterminer la position absolue et sur plusieurs tours de la colonne de direction. Le dispositif de type vernier comprend notamment une roue dentée principale (1000) solidaire préférentiellement de la structure aimantée (100). La rotation de la colonne de rotation entraine donc la rotation de la roue principale (1000) qui entraîne à son tour la rotation des roues satellites aimantés (1001, 1002) qui induit l'évolution du signal au niveau des sondes magnétosensibles (1003, 1004). Sur plusieurs tours de rotation de la colonne de direction, il est ainsi possible d'obtenir une position angulaire absolue de cette colonne.

Il peut bien sûr être envisagé d'utiliser n'importe quelle variante de capteur de position selon l'invention avec n'importe quel dispositif de détection de position absolu, cet exemple de la figure 20 n'étant nullement limitatif dans sa réalisation.

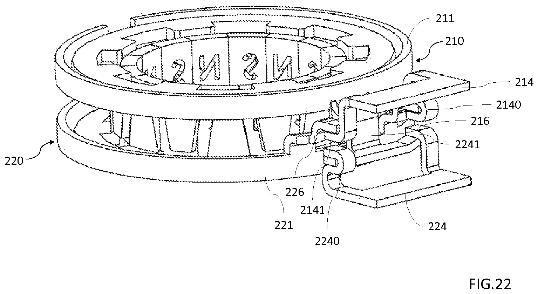

Les figure 21 et 22 illustrent des structures présentant des modes de réalisation pour la liaison mécanique et magnétique entre les zones de collecte secondaires (214, 224) et les zones de collecte primaires (211, 221). Sur un des côtés les zones de collecte secondaires (214, 224) présentent en leurs extrémités des parties recourbées en forme de U (2140, 2240) permettant une liaison par « clipsage » sur une extrémité plane des prolongements (216, 226). Sur l'autre côté, les zones de collecte secondaires (214, 224) présentent une surface plane (2141, 2241) en contact avec une extrémité plane des prolongements (216, 226) permettant une liaison par soudure au niveau du contact. La forme de U n'étant pas limitative, nous pouvons imaginer d'autres modes de clipsage par des formes complémentaire garantissant un maintien par déformation mécanique.

Il peut bien sûr être envisagé d'utiliser n'importe quelle combinaison des modes de fixation présentés ou suggérés, l'emploi de modes de fixation différents dans les figures 21 et 22 n'ayant pour objectif que d'en illustrer la diversité, les revendications définissant l'objet de la protection demandée.

## Revendications

1. - Capteur de position, notamment destiné à la détection de la torsion d'une colonne de direction, constitué d'une première structure magnétique aimantée rotorique (100) comprenant une pluralité d'aimants, de deux pièces de collecte de flux (210, 220) qui définissent au moins un entrefer dans lequel est placé au moins un élément magnéto sensible (300, 301, 302), chaque pièce de collecte (210, 220) présentant au moins une zone de collecte primaire (211, 221) prolongée par au moins un prolongement (216, 219, 226, 229) présentant au moins une zone de collecte secondaire (214, 215, 224, 225), lesdites zones de collecte secondaire (214, 215, 224, 225) étant terminées par des épanouissements plans formant les deux pôles dudit entrefer et le plan médian transversal (350) dudit entrefer coupant au moins un desdits prolongements (216, 219, 226, 229), et lesdites au moins une zone de collecte primaires (211) de la première pièce de collecte (210) possédant au moins une surface de collecte (211B) de plan médian PP1, lesdites au moins une zone de collecte primaires (221) de la deuxième pièce de collecte (220) possédant au moins une surface de collecte (221B) de plan médian PP2, lesdites au moins une zone de collecte secondaires (214, 215) possédant au moins une surface de collecte (214B, 215B) de la première pièce de collecte (210) de plan médian PS1, et lesdites au moins une zone de collecte secondaires (224, 225) de la deuxième pièce de collecte (220) possédant au moins une surface de collecte (224B, 225B) de plan médian PS2 PP1 n'étant pas perpendiculaire à PS2 ou PP2 n'étant pas perpendiculaire à PS1, **caractérisé en ce qu'**il est collecté autant de champ perturbateur avec la zone de collecte primaire qu'avec la zone de collecte secondaire et au niveau de l'entrefer de mesure les deux flux de champs collectés sont inversés relativement l'un par rapport à l'autre.

2. - Capteur de position selon la revendication 1 **caractérisé en ce qu'**au moins une couronne dentée (130, 140) est positionnée en regard de la structure aimantée (100).

3. - Capteur de position selon la revendication 1 **caractérisé en ce que** ledit plan médian (350) est parallèle aux plans des zones de collecte primaire (211, 221).

4. - Capteur de position selon la revendication 1 **caractérisé en ce que** au moins une zone de collecte primaire (211, 221) présente en outre une surface additionnelle (211A, 221A) destinée à collecter le flux utile venant de ladite structure magnétique aimantée rotorique (100).

5. - Capteur de position selon la revendication 1 **caractérisé en ce que** lesdites au moins une zone de collecte primaires (211) possèdent au moins une surface de collecte additionnelle (211C, 211D) de plan médian PP1', lesdites au moins une zone de collecte primaires (221) possèdent au moins une surface de collecte (221C, 221D) de plan médian PP2', lesdites au moins une zone de collecte secondaires (214, 215) possèdent au moins une surface de collecte (214B, 215B) de plan médian PS1', et lesdites au moins une zone de collecte secondaires (224, 225) possèdent au moins une surface de collecte (224B, 225B) de plan médian PS2', **en ce que** PP1' ne soit pas perpendiculaire à PS2' ou PP2' ne soit pas perpendiculaire à PS1'.

6. - Capteur de position selon la revendication 1 **caractérisé en ce que** ledit prolongement (216, 219, 226, 229) s'étend axialement et perpendiculairement au plan de ladite zone de collecte primaire (211) au-delà dudit plan médian transversal (350).

7. - Capteur de position selon la revendication 1 **caractérisé en ce que** la surface totale de la zone de collecte secondaire (214, 215, 224, 225) est égale à la surface totale de la zone de collecte primaire (211, 221).

8. - Dispositif de détection de position absolue d'une colonne de direction **caractérisé en ce qu'**il comprend en outre un capteur de position destiné à la détection de la torsion de ladite colonne conforme à la revendication 1.

## Patentansprüche

1. Positionssensor, der insbesondere für die Erfassung der Torsion einer Lenksäule bestimmt ist, bestehend aus einer ersten rotorartigen magnetisierten Magnetstruktur (100), umfassend eine Vielzahl von Magneten, zwei Flusssammelstücke (210, 220), die mindestens einen Luftspalt begrenzen, in dem mindestens ein magnetempfindliches Element (300, 301, 302) platziert ist, wobei jedes Sammelstück (210, 220) mindestens eine Primärsammelzone (211, 221) aufweist, die durch mindestens eine Verlängerung (216, 219, 226, 229) verlängert ist, die mindestens eine Sekundärsammelzone (214, 215, 224, 225) aufweist, wobei die Sekundärsammelzonen (214, 215, 224, 225) durch ebene Erweiterungen abgeschlossen sind, die die zwei Pole des Luftspalts ausbilden, und wobei die Quermittelebene (350) des Luftspalts mindestens eine der Verlängerungen (216, 219, 226, 229) schneidet und die mindestens eine Primärsammelzone (211) des ersten Sammelstücks (210) mindestens eine Sammeloberfläche (211B) einer Mittelebene PP1 besitzt, wobei die mindestens eine Primärsammelzone (221) des zweiten Sammelstücks (220) mindestens eine Sammeloberfläche (221B) der Mittelebene PP2 besitzt, die mindestens eine Sekundärsammelzone (214, 215) mindestens eine Sammeloberfläche (214B, 215B) des ersten Sammelstücks (210) der Mittelebene PS1 besitzt und die mindestens eine Sekundärsammelzone (224, 225) des zweiten Sammelstücks (220) mindestens eine Sammeloberfläche (224B, 225B) der Mittelebene PS2 besitzt, wobei PP1 nicht senkrecht zu PS2 ist oder PP2 nicht senkrecht zu PS1 ist, **dadurch gekennzeichnet, dass** genauso viel Störfeld mit der Primärsammelzone wie mit der Sekundärsammelzone gesammelt wird und an dem Messluftspalt die zwei Flüsse der gesammelten Felder relativ zueinander umgekehrt sind.

2. Positionssensor nach Anspruch 1, **dadurch gekennzeichnet, dass** mindestens ein Zahnring (130, 140) gegenüber der magnetischen Struktur (100) positioniert ist.

3. Positionssensor nach Anspruch 1, **dadurch gekennzeichnet, dass** die Mittelebene (350) parallel zu den Ebenen der Primärsammelzonen (211, 221) ist.

4. Positionssensor nach Anspruch 1, **dadurch gekennzeichnet, dass** mindestens eine Primärsammelzone (211, 221) ferner eine zusätzliche Oberfläche (211A, 221A) aufweist, die dazu bestimmt ist, den Hauptfluss zu sammeln, der von der rotorartigen magnetisierten Magnetstruktur (100) kommt.

5. Positionssensor nach Anspruch 1, **dadurch gekennzeichnet, dass** die mindestens eine Primärsammelzone (211) mindestens eine zusätzliche Sammeloberfläche (211C, 211D) der Mittelebene PP1' besitzt, die mindestens eine Primärsammelzone (221) mindestens eine Sammeloberfläche (221C, 221D) der Mittelebene PP2' besitzt, wobei die mindestens eine Sekundärsammelzone (214, 215) mindestens eine Sammeloberfläche (214B, 215B) der Mittelebene PS1' besitzt und die mindestens eine Sekundärsammelzone (224, 225) mindestens eine Sammeloberfläche (224B, 225B) der Mittelebene PS2' besitzt, **dass** PP1' nicht senkrecht zu PS2' ist oder PP2' nicht senkrecht zu PS1' ist.

6. Positionssensor nach Anspruch 1, **dadurch gekennzeichnet, dass** sich die Verlängerung (216, 219, 226, 229) axial und rechtwinklig zu der Ebene der Primärsammelzone (211) über die Quermittelebene (350) hinaus erstreckt.

7. Positionssensor nach Anspruch 1, **dadurch gekennzeichnet, dass** die Gesamtoberfläche der Sekundärsammelzone (214, 215, 224, 225) gleich der Gesamtoberfläche der Primärsammelzone (211, 221) ist.

8. Vorrichtung zum Erfassen der absoluten Position einer Lenksäule,
**dadurch gekennzeichnet, dass** sie ferner einen Positionssensor umfasst, der dazu bestimmt ist, die Torsion der Säule nach Anspruch 1 zu erfassen.

## Claims

1. Position sensor, in particular designed to detect the torsion in a steering column, made up of a first magnetized magnetic rotor structure (100) comprising a plurality of magnets, two flux-collecting components (210, 220) which define at least one air gap in which at least one magnetically sensitive element (300, 301, 302) is placed, each collecting component (210, 220) having at least one primary collecting zone (211, 221) extended by at least one extension (216, 219, 226, 229) having at least one secondary collecting zone (214, 215, 224, 225), said secondary collecting zones (214, 215, 224, 225) ending with flattened shoes forming the two poles of said air gap and the transverse mid-plane (350) of said air gap intersecting at least one of said extensions (216, 219, 226, 229), and said at least one primary collecting zone (211) of the first collecting component (210) having at least one collecting surface (211B) with mid-plane PP1, said at least one primary collecting zone (221) of the second collecting component (220) having at least one collecting surface (221B) with mid-plane PP2, said at least one secondary collecting zone (214, 215) having at least one collecting surface (214B, 215B) for the first collecting component (210) with mid-plane PS1, and said at least one secondary collecting zone (224, 225) of the second collecting component (220) having at least one collecting surface (224B, 225B) with mid-plane PS2, PP1 not being perpendicular to PS2 or PP2 not being perpendicular to PS1, **characterized in that** as much interference field is collected with the primary collecting zone as with the secondary collecting zone and at the measurement air gap the two flows of collected fields are reversed relative to one another.

2. Position sensor according to claim 1, **characterized in that** at least one toothed ring (130, 140) is positioned opposite the magnetized structure (100).

3. Position sensor according to claim 1, **characterized in that** said mid-plane (350) is parallel to the planes of the primary collecting zones (211, 221).

4. Position sensor according to claim 1, **characterized in that** at least one primary collecting zone (211, 221) furthermore has an additional surface (211A, 221A) intended to collect the useful flux coming from said magnetized magnetic rotor structure (100).

5. Position sensor according to claim 1, **characterized in that** said at least one primary collecting zone (211) has at least one additional collecting surface (211C, 211D) with mid-plane PP1', said at least one primary collecting zone (221) has at least one collecting surface (221C, 221D) with mid-plane PP2', said at least one secondary collecting zone (214, 215) has at least one collecting surface (214B, 215B) with mid-plane PS1', and said at least one secondary collecting zone (224, 225) has at least one collecting surface (224B, 225B) with mid-plane PS2', **in that** PP1' is not perpendicular to PS2' or PP2' is not perpendicular to PS1'.

6. Position sensor according to claim 1, **characterized in that** said extension (216, 219, 226, 229) extends axially and perpendicular to the plane of said primary collecting zone (211) beyond said transverse mid-plane (350).

7. Position sensor according to claim 1, **characterized in that** the total area of the secondary collecting zone (214, 215, 224, 225) is equal to the total area of the primary collecting zone (211, 221).

8. Device for detecting the absolute position of a steering column,
**characterized in that** it further comprises a position sensor designed to detect the torsion of said column in accordance with claim 1.
